(19) Europäisches Patentamt
European Patent Office
Office européen des brevets

(11) **EP 1 739 755 B1**

(12) **EUROPEAN PATENT SPECIFICATION**

(45) Date of publication and mention
of the grant of the patent:
**10.08.2011 Bulletin 2011/32**

(51) Int Cl.:
***H01L 31/068*** (2006.01)

(21) Application number: **06011518.5**

(22) Date of filing: **02.06.2006**

(54) **Tandem photovoltaic device**

Tandem photovoltaisches Bauelement

Dispositif photovoltaïque tandem

(84) Designated Contracting States:
**AT BE BG CH CY CZ DE DK EE ES FI FR GB GR HU IE IS IT LI LT LU LV MC NL PL PT RO SE SI SK TR**

(30) Priority: **30.06.2005 JP 2005190930**

(43) Date of publication of application:
**03.01.2007 Bulletin 2007/01**

(73) Proprietor: **SANYO ELECTRIC CO., LTD.**
**Moriguchi-City, Osaka 570-8677 (JP)**

(72) Inventor: **Shima, Masaki**
**Uji-city**
**Kyoto 611-0031 (JP)**

(74) Representative: **TER MEER - STEINMEISTER & PARTNER GbR**
**Patentanwälte**
**Mauerkircherstrasse 45**
**81679 München (DE)**

(56) References cited:
**JP-A- 2003 046 101      US-A- 5 288 338**
**US-A1- 2002 011 264      US-A1- 2004 149 330**

**Description**

**BACKGROUND OF THE INVENTION**

**Field of the Invention**

The present invention relates to a stacked photovoltaic device which includes a photovoltaic unit having an amorphous silicon layer serving as a photoelectric conversion layer, and a photovoltaic unit having a microcrystalline silicon layer serving as a photoelectric conversion layer and succeeding backwardly from the former photovoltaic unit closer to a light incidence plane.

**Description of the Related Art**

A stacked photovoltaic device consisting of a multilayer of photovoltaic units is known to improve a photoelectric conversion efficiency. In order to improve a photoelectric conversion efficiency, such a stacked photovoltaic device is built by stacking photovoltaic units having different band gaps which absorb lights in respective regions of the solar spectrum.
This type of stacked photovoltaic unit is proposed such as in Japanese Patent Laying-Open No. Hei 11-243218. It uses amorphous silicon as a photoelectric conversion layer, i.e., an i-type layer of a photovoltaic unit, and microcrystalline silicon as a photoelectric conversion layer, i.e., an i-type layer of a photovoltaic unit succeeding backwardly from the former photovoltaic unit closer to a light incidence plane. A photovoltaic element using microcrystalline silicon as the photoelectric conversion layer exhibits a smaller conversion efficiency drop, after photodegradation and thus absorbs lights in a wider region up to an infrared region of the spectrum, relative to a photovoltaic element using the amorphous silicon layer as the photoelectric conversion layer . Accordingly, a conversion efficiency can be improved by locating a first photovoltaic unit using an amorphous silicon layer as an i-type layer closer to a light incidence plane, positioning a second photovoltaic unit using a microcrystalline silicon layer as an i-type layer rearward of the first photovoltaic unit, stacking and connecting them in series.
However, the photovoltaic element using amorphous silicon as the photoelectric conversion layer is susceptible to photodegradation, while the photovoltaic element using microcrystalline silicon as the photoelectric conversion layer is little susceptible to photodegradation. Accordingly, in the stacked photovoltaic unit having such units connected in series, the photovoltaic unit using the amorphous silicon is degraded after prolonged exposure to a light, resulting in a problematic drop of an overall photovoltaic power output of the stacked photovoltaic device.
US 20020011264 deals with the problem of light induced degradation of tandem mc/alpha silicon solar cells and suggests having the current controlled by the microcristalline part of the tandem cell.

**SUMMARY OF THE INVENTION**

It is an object of the present invention to provide a stacked photovoltaic device which has a first photovoltaic unit using an amorphous silicon layer as a photoelectric conversion layer and a second photovoltaic unit using a microcrystalline silicon layer as a photoelectric conversion layer and succeeding backwardly from the first photovoltaic unit closer to a light incidence plane, and which shows the retarded photodegradation in the long-term service.
The present invention provides a stacked photovoltaic device which includes a first photovoltaic unit and a second photovoltaic unit succeeding backwardly from the first photovoltaic unit closer to a light incidence plane. The first photovoltaic unit has a multilayer structure comprising a one conductive type non-single-crystalline semiconductor layer, an amorphous silicon layer which is substantially intrinsic and serves as a photoelectric conversion layer contributing to power generation, and another conductive type non-single-crystalline semiconductor layer. The second photovoltaic unit has a multilayer structure comprising a one conductive type non-single-crystalline semiconductor layer, a micro-rystalline silicon layer which is substantially intrinsic and serves as a photoelectric conversion layer contributing to power generation, and another conductive type non-single-crystalline semiconductor layer. The microcrystalline silicon layer as the photoelectric conversion layer in the second photovoltaic unit has a ratio $\alpha_2$ (= I(Si-O)/I(Si-H)) greater than a ratio $\alpha_1$ (= I(Si-O)/I(Si-H)) of the amorphous silicon layer as the photoelectric conversion layer in the first photovoltaic unit, where I(Si-O) is a peak area for the Si-O stretching mode of each silicon layer and I(Si-H) is a peak area for the Si-H stretching mode of each silicon layer when measured by infrared absorption spectroscopy. Also, a short-circuit current $Isc_2$ of the second photovoltaic unit is greater than a short-circuit current $Isc_1$ of the first photovoltaic unit.
As described above, in the stacked photovoltaic device of the present invention, $\alpha_2$ of the microcrystalline silicon layer in the second photovoltaic unit is greater in value than $\alpha_1$ of the amorphous silicon layer in the first photovoltaic unit. In this condition, a larger amount of oxygen as an impurity is incorporated in the microcrystalline silicon layer than in the amorphous silicon layer. Since the microcrystalline silicon has a higher crystallinity than the amorphous silicon,

$\alpha_2$ of the microcrystalline silicon layer becomes about comparable or smaller than $\alpha_1$ of the amorphous silicon layer, when the both silicon layers are formed under conventional normal conditions. However in the present invention, the microcrystalline silicon layer is formed with the intention to render $\alpha_2$ greater than $\alpha_1$. Thus, the stacked photovoltaic device of the present invention initially exhibits a lower photoelectric conversion efficiency, compared to conventional stacked photovoltaic devices in which $\alpha_2$ is about comparable or smaller than $\alpha_1$. However, the stacked photovoltaic device of the present invention is designed such that the short-circuit current $Isc_2$ of the second photovoltaic unit exceeds the short-circuit current $Isc_1$ of the first photovoltaic unit. Since an overall short-circuit current of the stacked photovoltaic device is governed by the current value of the photovoltaic unit having a smaller short-circuit current, degradation of the initial characteristics of the second photovoltaic unit does not provide a significant influence on the device at large.

In the present invention, $\alpha_2$ is rendered larger than $\alpha_1$, as described above. This causes slight degradation of initial characteristics but is effective in retarding photodegradation in the long-term service. Thus, total generated energy in the long-term service is improved, relative to conventional devices.

In the present invention, $\alpha_2$ of the microcrystalline silicon layer in the second photovoltaic unit is designed to exceed $\alpha_1$ of the amorphous silicon layer in the first photovoltaic unit. This design can be realized by increasing an oxygen content of the microcrystalline silicon layer in the second photovoltaic unit. The oxygen content can be increased, for example, by increasing a reaction pressure when a thin film is formed or decreasing a hydrogen concentration when a reaction gas is diluted with hydrogen. Alternatively, oxygen can be introduced in the microcrystalline silicon layer by adding an oxygen-containing gas, such as $CO_2$, to a reaction gas. Such incorporation of oxygen into the microcrystalline silicon layer increases its Si-O bond content and renders $\alpha_2$ greater than $\alpha_1$.

Also in the present invention, the short-circuit current $Isc_2$ of the second photovoltaic unit is designed to exceed the short-circuit current $Isc_1$ of the first photovoltaic unit. The value of a current generated in each photovoltaic unit of the stacked photovoltaic device can be calculated from a spectral sensitivity measured by a constant-energy spectroscopy. A measurement theory is as follows.

When desired to measure a spectral sensitivity of a photovoltaic unit A, the photovoltaic device consisting of two superimposed photovoltaic units A and B is exposed to a bias light, i.e., a light having a wavelength range that will be absorbed by the photovoltaic unit B. Then, the photovoltaic unit B is brought to a generating state in which it reduces a resistance, while the photovoltaic unit A remains in a non-generating state. Subsequent exposure to a monochromatic probe light (having a certain wavelength) while chopped results in production of carriers. A collection efficiency (energy generated by the photovoltaic unit/energy of a light entering the photovoltaic unit) can be then determined by withdrawing the produced carriers and measuring their amount (detected in terms of a voltage value) with the use of a lockin amplifier. Since the photovoltaic unit B in its generating state is highly conductive, it permits the flow of the produced carriers. In this condition, a wavelength of the probe light is scanned to thereby determine the spectral sensitivity of the photovoltaic unit.

The following specific procedure can be utilized to measure a short-circuit current of each unit cell in a stacked photovoltaic device having a front cell and a bottom cell arranged in layers.

(1) A photovoltaic device as an object of measurement is set in a constant energy spectroscope.
(2) In an attempt to measure a spectral sensitivity of the front cell, a short wavelength cut filter (e.g., having a cutoff wavelength of 570 nm) is set in a path of a white bias light.
(3) The photovoltaic device is exposed to a monochromic probe light and scanned in the wavelength range of 340 nm - 1,200 nm. In this case, an exposure intensity is adjusted such that irradiation is carried out at a predetermined energy intensity (or a predetermined photon number).
(4) In the measurement data, a spectral sensitivity (external collection efficiency) at a certain wavelength is multiplied by a spectral intensity of a solar radiation, as prescribed in a standard such as TC 82, and integrated over the 340 nm - 1,200 nm wavelength range. This calculation results in obtaining a value of current produced in the front cell.
(5) In an attempt to measure a spectral sensitivity of the bottom cell, a long wavelength cut filter (e.g., having a cutoff wavelength of 480 nm) is set in a path of a white bias light. The preceding procedures (3) and (4) are then followed to calculate a value of current produced in the bottom cell.

In the present invention, $\alpha_2$ of the microcrystalline silicon layer in the second photovoltaic unit is designed to exceed $\alpha_1$ of the amorphous silicon layer in the first photovoltaic unit. Also, the short-circuit current $Isc_2$ of the second photovoltaic unit is designed to exceed the short-circuit current $Isc_1$ of the first photovoltaic unit. These features are effective in retarding photodegradation of the device in the long-term service. The associated action and effect are described below.

The output of the stacked photovoltaic device is roughly related to the respective outputs of the photovoltaic unit cells therein by the following equations.

Open-circuit voltage (Voc) of the stacked

photovoltaic device = sum of open-circuit voltages of the unit cells


Short-circuit current (Isc) of the stacked

photovoltaic device = least among current values of the unit cells


Fill factor (F.F.) of the stacked photovoltaic device = lowest among fill factors of the unit cells


Also, the photovoltaic element using amorphous silicon as the photovoltaic layer, when irradiated, shows degradation, primarily in fill factor and open-circuit voltage. In contrast, the photovoltaic element using microcrystalline silicon as the photovoltaic layer is little degraded by irradiation. Even in case it is photodegraded, only a slight reduction of fill factor results.

A photovoltaic device embodiment of the present invention which uses the first photovoltaic unit as a front cell and the second photovoltaic unit as a bottom cell is below illustrated to describe the action and effect of the present invention.

In the present invention, the short-circuit current of the second photovoltaic unit (bottom cell) is higher than that of the first photovoltaic unit (front cell). Accordingly, the short-circuit current of the photovoltaic device consisting of a stack of those units is governed by the short-circuit current value of the first photovoltaic unit (front cell). Also in the present invention, $\alpha_2$ of the microcrystalline silicon layer in the second photovoltaic unit (bottom cell) exceeds $\alpha_1$ of the amorphous silicon layer in the first photovoltaic unit (front cell). Thus, in the photovoltaic device embodiment of the present invention, the bottom cell exhibits the inferior fill factor (F.F.) to the front cell, as shown in Table 1.

Table 1 shows open-circuit voltages (Voc), short-circuit currents (Isc), fill factors (F.F.) and conversion efficiencies for the front cell, bottom cell and stacked cell consisting of the front and bottom cells arranged above each other, both initially and after irradiation. The parameter values in Table 1 are standardized by the parameter values of the front cell as 1.

[TABLE 1]

| Example (Initially) | | | | | | (After Irradiation) | | | | |
|---|---|---|---|---|---|---|---|---|---|---|
| | Voc | Isc | F.F. | Conversion Efficiency | | | Voc | Isc | F.F. | Conversion Efficiency |
| Front Cell | 1.00 | 1.00 | 1.00 | - | | Front Cell | 0.95 | 1.00 | 0.84 | - |
| Bottom Cell | 0.53 | 1.10 | 0.95 | - | $\rightarrow$ | Bottom Cell | 0.53 | 1.10 | 0.90 | - |
| Stacked Cell | 1.53 | 1.00 | 0.95 | 1.45 | | Stacked Cell | 1.48 | 1.00 | 0.84 | 1.24 ▲ 14.4% |

Next, the conventional photovoltaic device embodiment was provided in which $\alpha_2$ of a microcrystalline silicon layer in a bottom cell is almost comparable to $\alpha_1$ of an amorphous silicon layer in a front cell. Table 2 shows open-circuit voltages (Voc), short-circuit currents (Isc), fill factors (F.F.) and conversion efficiencies for such conventional front cell, bottom cell and stacked cell consisting of the front and bottom cells arranged above each other, both initially and after irradiation.

[TABLE 2]

| Comparative Example (Initially) | | | | | | (After Irradiation) | | | | |
|---|---|---|---|---|---|---|---|---|---|---|
| | Voc | Isc | F.F. | Conversion Efficiency | | | Voc | Isc | F.F. | Conversion Efficiency |
| Front Cell | 1.00 | 1.00 | 1.00 | - | | Front Cell | 0.95 | 1.00 | 0.84 | - |
| Bottom Cell | 0.53 | 1.10 | 1.00 | - | → | Bottom Cell | 0.53 | 1.10 | 1.00 | - |
| Stacked Cell | 1.53 | 1.00 | 1.00 | 1.53 | | Stacked Cell | 1.48 | 1.00 | 0.84 | 1.24 ▲ 19.0% |

As can be clearly seen from Tables 1 and 2, the stacked photovoltaic device embodiment of the present invention, while initially lower in conversion efficiency, exhibits a smaller drop in percentage of conversion efficiency after irradiation, compared to the conventional stacked photovoltaic device. This demonstrates the retarded photodegradation of the stacked photovoltaic device embodiment of the present invention in the long-term service.

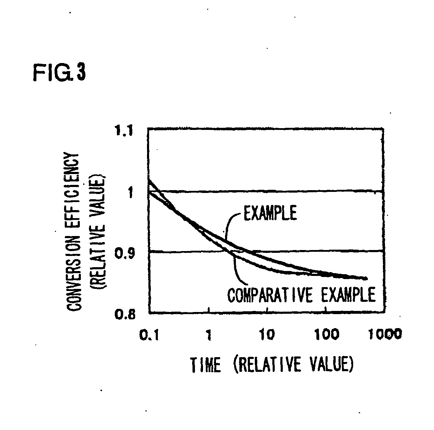

Figure 3 shows accelerated photodegradation test results for the photovoltaic device embodiment of the present invention and the conventional photovoltaic device embodiment. As shown in Figure 3, the conventional photovoltaic device shows a high rate of degradation and reaches a steady conversion efficiency in the early stage, while the photovoltaic device of the present invention shows a low rate of degradation and its conversion efficiency is stabilized in a later stage. This demonstrates that the photovoltaic device of this invention delivers a higher total power output than the conventional photovoltaic device.

In accordance with the present invention, a stacked photovoltaic device is provided which has a first photovoltaic unit using an amorphous silicon layer as a photoelectric conversion layer and a second photovoltaic unit using a microcrystalline silicon layer as a photoelectric conversion layer and succeeding backwardly from the first photovoltaic unit closer to a light incidence plane, and which shows a slower photodegradation in the long-term service and produces a higher total photovoltaic power output than conventional ones.

## BRIEF DESCRIPTION OF THE DRAWINGS

Figure 1 is a sectional view showing a stacked photovoltaic device embodiment of the present invention;

Figure 2 is a chart showing an infrared absorption spectrum of a photoelectric conversion layer in a front cell of the embodiment; and

Figure 3 is a graph showing a change in conversion efficiency of a stacked photovoltaic device of the present invention when subjected to an accelerated photodegradation test.

## DESCRIPTION OF THE PREFERRED EMBODIMENTS

The present invention is below described in detail by way of specific examples which are not intended to be limiting thereof.

(EXAMPLE)

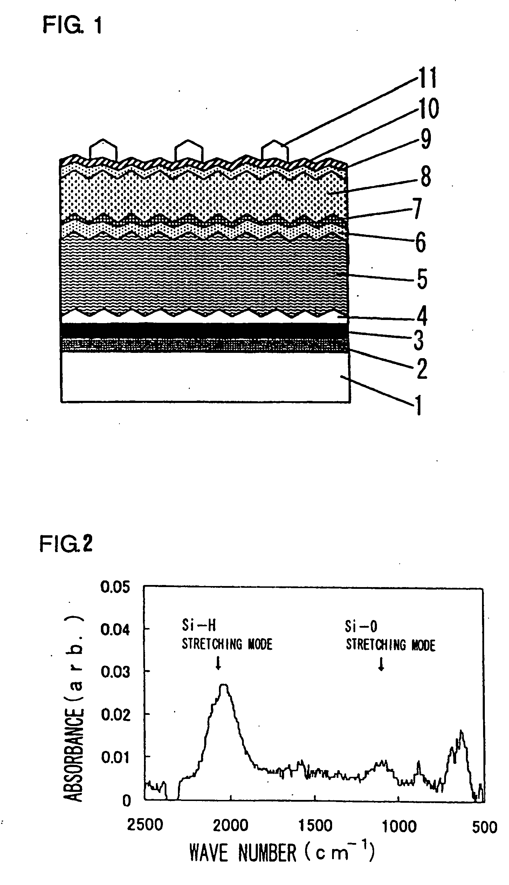

Figure 1 is a sectional view showing a stacked photovoltaic device in accordance with an embodiment of the present invention. The stacked photovoltaic device (tandem type photovoltaic device) shown in Figure 1 includes a first photovoltaic unit using an amorphous silicon layer as a photoelectric conversion layer and a second photovoltaic unit using a microcrystalline silicon layer as a photoelectric conversion layer, arranged in the sequence closer to a light incidence plane.

As shown in Figure 1, a substrate 1 carries thereon a polyimide layer 2 on which a back electrode 3 is disposed. An n-type microcrystalline silicon ($\mu$c-Si:H) layer 4 (20 nm thick), an intrinsic (i-type) microcrystalline silicon ($\mu$c-Si:H) layer 5 (2 $\mu$m thick) serving as a photoelectric conversion layer and a p-type microcrystalline silicon ($\mu$c-Si:H) layer 6 (20 nm thick) are sequentially formed on the back electrode 3. These n-type, intrinsic and p-type microcrystalline silicon layers 4, 5 and 6 constitute a second photovoltaic unit.

An n-type microcrystalline silicon ($\mu$c-Si:H) layer 7 (20 nm thick), an intrinsic (i-type) amorphous silicon (a-Si:H) layer 8 (300 nm thick) serving as a photoelectric conversion layer and a p-type amorphous silicon carbide (a-SiC:H)

5

layer 9 (20 nm thick), in sequence, are formed on the p-type microcrystalline silicon layer 6. A transparent top electrode 10 and a collector electrode 11 are sequentially provided on the p-type amorphous silicon carbide layer 9. The n-type microcrystalline silicon layer 7, intrinsic amorphous silicon layer 8 and p-type amorphous silicon carbide layer 9 constitute a first photovoltaic unit.

The substrate 1 is composed of a stainless steel (SUS 430, 0.15 mm thick). A polyimide resin is vapor deposited to a thickness of 20 $\mu$m and polymerized to provide the polyimide layer 2. Silver (Ag) is deposited by an RF magnetron sputtering process to a thickness of 200 nm to provide the back electrode 3.

Indium oxide (ITO) doped with tin oxide is deposited by an RF magnetron sputtering process to a thickness of 80 nm to provide the transparent top electrode 10. An Ag paste is coated to provide the collector electrode 11.

In this Example, a light enters a side of the device where the collector electrode 11 and transparent top electrode 10 are located. Accordingly, the first photovoltaic unit consisting of the n-type microcrystalline silicon layer 7, intrinsic amorphous silicon layer 8 and p-type amorphous silicon carbide layer 9 is located closer to a light incidence plane and thus constitutes a front cell. The second photovoltaic unit consisting of the n-type microcrystalline silicon layer 4, intrinsic microcrystalline silicon layer 5 and p-type microcrystalline silicon layers 6 is located backward of the first photovoltaic unit, i.e., remoter from the light incidence plane, to constitute a bottom cell. A substrate temperature, a reaction pressure, a radio-frequency power and a gas flow rate used to form a thin film for each layer of the first photovoltaic unit (front cell) and the second photovoltaic unit (bottom cell) are shown in Table 3.

[TABLE 3]

| Example | | Substrate Temperature (°C) | Reaction Pressure (Pa) | Radio-Frequency Power (W) | Gas Flow Rate (sccm) | |
|---|---|---|---|---|---|---|
| Bottom Cell | n-Type Layer | 160 | 133 | 100 | $SiH_4$<br>$H_2$<br>$PH_3$ | 3<br>200<br>0.06 |
| | Bottom Photoelectric Conversion Layer | 200 | 133 | 30 | $SiH_4$<br>$H_2$ | 20<br>400 |
| | p-Type Layer | 160 | 133 | 240 | $SiH_4$<br>$H_2$<br>$B_zH_6$ | 2<br>400<br>0.02 |
| Front Cell | n-Type Layer | 160 | 133 | 100 | $SiH_4$<br>$H_2$<br>$PH_3$ | 3<br>200<br>0.06 |
| | Front Photoelectric Conversion Layer | 160 | 11 | 5 | $SiH_4$ | 30 |
| | p-Type Layer | 160 | 33 | 240 | $SiH_4$<br>$H_2$<br>$CH_4$<br>$B_2H_6$ | 10<br>90<br>10<br>0.4 |

(COMPARATIVE EXAMPLE)

As a comparative example, the procedure of the preceding Example is followed, except that the conditions used to form the microcrystalline silicon layer as the photoelectric conversion layer of the bottom cell (second photovoltaic cell) are altered to those listed in Table 4, to fabricate a stacked photovoltaic de.vice. For the photoelectric conversion layer of the bottom cell, thin film-forming conditions are changed. Specifically, the radio-frequency power is changed from 30 W to 50 W, the $SiH_4$ flow rate is changed from 20 sccm to 10 sccm and the $H_2$ flow rate is left unchanged, as shown in Table 4.

[TABLE 4]

| Comparative Example | | Substrate Temperature (°C) | Reaction Pressure (Pa) | Radio-Frequency Power (W) | Gas Flow Rate (sccm) | |
|---|---|---|---|---|---|---|
| Bottom Cell | n-Type Layer | 160 | 133 | 100 | $SiH_4$ <br> $H_2$ <br> $PH_3$ | 3 <br> 200 <br> 0.06 |
| | Bottom Photoelectric Conversion Layer | 200 | 133 | 50 | $SiH_4$ <br> $H_2$ | 10 <br> 400 |
| | p-Type Layer | 160 | 133 | 240 | $SiH_4$ <br> $H_2$ <br> $B_2H_6$ | 2 <br> 400 <br> 0.02 |
| Front Cell | n-Type Layer | 160 | 133 | 100 | $SiH_4$ <br> $H_2$ <br> $PH_3$ | 3 <br> 200 <br> 0.06 |
| | Front Photoelectric Conversion Layer | 160 | 11 | 5 | $SiH_4$ | 30 |
| | p-Type Layer | 160 | 33 | 240 | $SiH_4$ <br> $H_2$ <br> $CH_4$ <br> $B_2H_6$ | 10 <br> 90 <br> 10 <br> 0.4 |

(Measurement of Infrared Absorption Spectrum of Photoelectric Conversion Layer)

Samples were prepared to measure infrared absorption spectra of respective photoelectric conversion layers of the front and bottom cells in Example and Comparative Example. The same back electrode as in the preceding Examples was formed on the same stainless steel substrate as in the preceding Examples. The n-type microcrystalline silicon layer and photoelectric conversion layer of each cell were then sequentially formed on the back electrode to prepare samples. By using these samples, infrared absorption spectra of the individual photoelectric conversion layers were measured.

Figure 2 is a chart showing an infrared absorption spectrum of the photoelectric conversion layer of the front cell in Example. This infrared absorption spectrum was measured by infrared reflection spectroscopy. Specifically, measurement was performed using an infrared reflection spectrometer JEOL JIP-100 under the following conditions: specular reflection measurement mode (integrated ten times), incident angle of an infrared radiation = 70 degrees (with respect to a normal of a sample), parallel polarization, and measurement range = 400 - 4,000 $cm^{-1}$ (resolving power: 4 $cm^{-1}$).

As shown in Figure 2, a number of peaks appear in the infrared absorption spectrum. Among them, an Si-H stretching mode appearing around 2,000 $cm^{-1}$ and an Si-O stretching mode appearing around 1,100 $cm^{-1}$ are generally used in evaluating film properties.

The ratio $\alpha$ (= I(Si-O)/I(Si-H)) of a peak area I(Si-O) for the Si-O stretching mode around 1,100 $cm^{-1}$ to a peak area I(Si-H) for the Si-H stretching mode around 2,000 $cm^{-1}$ was determined for the photoelectric conversion layers in Example and Comparative Example. Such ratios $\alpha$ of the front and bottom cells are designated as $\alpha_1$ and $\alpha_2$, respectively. The ratios $\alpha_1$ and $\alpha_2$ in Example and Comparative Example are shown in Table 5.

[TABLE 5]

| | $\alpha_2$ | $\alpha_1$ |
|---|---|---|
| Example | 0.138 | 0.043 |

(continued)

|  | $\alpha_2$ | $\alpha_1$ |
|---|---|---|
| Comparative Example | 0.039 | 0.043 |

As clearly shown in Table 5, $\alpha_2$ is less than $\alpha_1$ in the stacked photovoltaic device of Comparative Example, while $\alpha_2$ is greater than $\alpha_1$ in the stacked photovoltaic device of Example. This is believed due to the reduced relative concentration of hydrogen in the gas flow, in the formation of the photoelectric conversion layer of the bottom cell, that caused oxygen to be incorporated in the microcrystalline silicon layer and, as a result, increased Si-O bonds therein.

(Measurement of Short-circuit Current in Front and Bottom Cells)

The respective short-circuit current values $Isc_1$ and $Isc_2$ of the front cell (first photovoltaic unit) and bottom cell (second photovoltaic unit) in each of the devices of Example and Comparative Example were determined using the preceding method for measuring a spectral sensitivity by a constant energy spectroscopy. The results are shown in Table 6. The values given in Table 6 are those standardized using the short-circuit current value $Isc_1$ of the front cell in Example.

[TABLE 6]

|  | Standardized Short-Circuit Current | |
|---|---|---|
|  | Front Cell ($Isc_1$) | Bottom Cell ($Isc_2$) |
| Example | 1.00 | 1.04 |
| Comparative Example | 1.00 | 0.97 |

As shown in Table 6, the current value $Isc_2$ of the bottom cell is designed to exceed the current value $Isc_1$ of the front cell in Example in accordance with the present invention.

(Evaluation of Photodegradation)

Each of the stacked photovoltaic devices of Example and Comparative Example was irradiated for a long period and then its characteristics were evaluated. Specifically, each device while its terminals left open was irradiated for 160 minutes under the conditions of AM-1.5, 500 mW/cm$^2$ and 25 °C. Thereafter, its characteristics were measured under the conditions of AM-1.5, 100 mW/cm$^2$ and 25 °C. The measurement results of conversion efficiency, open-circuit voltage, short-circuit current and fill factor are given in Table 7, in terms of standardized values (= 1 - percentage photodegradation) obtained by dividing their outputs after irradiation by their initial outputs before irradiation.

[TABLE 7]

|  | Standardized Conversion Efficiency | Standardized Open-Circuit Voltage | Standardized Short-Circuit Current | Standardized Fill Factor |
|---|---|---|---|---|
| Example | 0.86 | 0.98 | 0.98 | 0.90 |
| Comparative Example | 0.81 | 0.99 | 0.98 | 0.84 |

As can be seen from Table 7, the device of Example exhibits a higher conversion efficiency after irradiation than the device of Comparative Example. Because current values and fill factors of cells are balanced to determine characteristics of the photovoltaic unit cell, as discussed above, the output of the stacked photovoltaic device are little affected by the initially low conversion efficiency of the bottom cell alone that occurs when $\alpha_2$ is rendered greater than $\alpha_1$. Thus, the initial drop of conversion efficiency is not very significant. As also described above, the fill factor and open-circuit voltage of the photovoltaic unit after irradiation are degraded if it uses the amorphous silicon layer as the photoelectric conversion layer but are little degraded if it uses the microcrystalline silicon layer as the photoelectric conversion layer. Therefore, the stacked photovoltaic device of the present invention after irradiation is unsusceptible to influence from the bottom cell using the microcrystalline silicon layer as the photoelectric conversion layer, which initially shows a low conversion efficiency, and is thus able to exhibit a high conversion efficiency, as shown in Table 7. Also, the photovoltaic device in accordance with the present invention has been found to show a lower time constant (speed) for photodegradation than conventional ones, as described above. Accordingly, a total photovoltaic capacity over a long period is higher in the photovoltaic device in accordance with the present invention than in conventional ones.

In the preceding Example, the stacked photovoltaic device is described to consist of two superimposed layers, i.e., the front cell and bottom cell. However, the present invention is not limited to this construction. The stacked photovoltaic device may consist of three or more layers of photovoltaic units. For example, another photovoltaic unit may be added such that it is interposed between the first and second photovoltaic units in the present invention, or succeeds forwardly from the first photovoltaic unit remoter from the light incidence plane or backwardly from the second photovoltaic unit closer to the light incidence plane.

Although a stainless steel substrate is used in the preceding Example, the type of the substrate material is not limited thereto. Other metals such as iron, molybdenum and aluminum, and various alloys are also applicable. Also in the preceding Example, a polyimide layer is provided on such a metal substrate to electrically separate the substrate from the other conductors. However, other resins such as polyethersulfone (PES) may be used to form such a resin layer for the insulation purpose. Alternatively, an insulating film such as of $SiO_2$ may be deposited on the substrate.

Also, the formation of a surface structure having some degree of unevenness on a back side of the photovoltaic device is known to cause light scattering that is expected to provide a light confining effect and, as a result, improve a conversion efficiency. In the present invention, such an uneven surface shape may be imparted to a resin layer by incorporating about 100 $\mu$m diameter particles such as of $SiO_2$ or $TiO_2$ into a resin such as polyimide or polyethersulfone, for example.

## Claims

1. A stacked photovoltaic device which includes a first photovoltaic unit and a second photovoltaic unit succeeding backwardly from the first photovoltaic unit closer to a light incidence plane, said first photovoltaic unit having a multilayer structure comprising a one conductive type non-single-crystalline semiconductor layer, an amorphous silicon layer which is substantially intrinsic and serves as a photoelectric conversion layer contributing to power generation and another conductive type non-single-crystalline semiconductor layer, said second photovoltaic unit having a multilayer structure comprising a one conductive type non-single-crystalline semiconductor layer, a microcrystalline silicon layer which is substantially intrinsic and serves as a photoelectric conversion layer contributing to power generation and another conductive type non-single-crystalline semiconductor layer;
said stacked photovoltaic device being **characterized in that** said microcrystalline silicon layer as the photoelectric conversion layer in the second photovoltaic unit has a ratio $\alpha_2$ (= I(Si-O)/I(Si-H)) greater than a ratio $\alpha_1$ (= I(Si-O)/I(Si-H))of said amorphous silicon layer as the photoelectric conversion layer in the first photovoltaic unit, where I(Si-O) is a peak area for the Si-O stretching mode of each silicon layer and I(Si-H) is a peak area for the Si-H stretching mode of each silicon layer, when measured by infrared absorption spectroscopy; and a short-circuit current $Isc_2$ of the second photovoltaic unit is greater than a short-circuit current $Isc_1$ of the first photovoltaic unit.

2. The stacked photovoltaic device as recited in claim 1, **characterized in that** each of said non-single-crystalline semiconductor layers is a non-single-crystalline silicon layer or a non-single-crystalline silicon alloy layer.

## Patentansprüche

1. Gestapelte photovoltaische Vorrichtung, die eine erste photovoltaische Einheit und eine zweite photovoltaische Einheit, die der ersten photovoltaischen Einheit rückwärts gerichtet näher an einer Lichteinfallsebene folgt, umfasst, wobei die erste photovoltaische Einheit eine Mehrschichtstruktur aufweist, die eine leitfähige nicht-einkristalline Halbleiterschicht, eine amorphe Siliziumschicht, die im Wesentlichen intrinsisch ist und als photoelektrische Wandlungsschicht, die zur Stromerzeugung beiträgt, dient, und eine andere leitfähige nicht-einkristalline Halbleiterschicht umfasst,
wobei die zweite photovoltaische Einheit eine Mehrschichtstruktur aufweist, die eine leitfähige nicht-einkristalline Halbleiterschicht, eine mikrokristalline Siliziumschicht, die im Wesentlichen intrinsisch ist und als photoelektrische Wandlungsschicht, die zur Stromerzeugung beiträgt, dient, und eine andere leitfähige nicht-einkristalline Halbleiterschicht umfasst;
wobei die gestapelte photovoltaische Vorrichtung **dadurch gekennzeichnet ist, dass** die mikrokristalline Siliziumschicht, die als photoelektrische Wandlungsschicht in der zweiten photovoltaischen Einheit dient, ein Verhältnis $\alpha_2$ (=I(Si-O)/I(Si-H)) aufweist, das größer als ein Verhältnis $\alpha_1$ (=I(Si-O)/I(Si-H)) der amorphen Siliziumschicht ist, die als photoelektrische Wandlungsschicht in der ersten photovoltaischen Einheit dient, wobei I(Si-O) eine Peakfläche der Si-O Streckmode einer jeden Siliziumschicht und I(SI-H) eine Peakfläche der Si-H Streckmode einer jeden Siliziumschicht ist, wenn mit Infrarotabsorptionsspektroskopie gemessen wird; und ein Kurzschlussstrom Isc$_2$ der zweiten photovoltaischen Einheit größer ist als ein Kurzschlussstrom Isc$_1$ der ersten photovoltaischen Einheit.

**2.** Gestapelte photovoltaische Vorrichtung nach Anspruch 1, **dadurch gekennzeichnet, dass** jede der nicht-einkristallinen Halbleiterschichten eine nicht-einkristalline Siliziumschicht oder eine nicht-einkristalline Siliziumlegierungsschicht ist.

**Revendications**

**1.** Dispositif photovoltaïque empilé qui comprend une première unité photovoltaïque et une seconde unité photovoltaïque en succession vers l'arrière par rapport à la première unité photovoltaïque plus près d'un plan d'incidence de lumière, ladite première unité photovoltaïque ayant une structure multicouche se composant d'une couche de semi-conducteur non monocristallin de type conducteur, d'une couche de silicium amorphe qui est sensiblement intrinsèque et qui sert de couche de conversion photoélectrique contribuant à la génération d'énergie et d'une autre couche de semi-conducteur non monocristallin de type conducteur, ladite seconde unité photovoltaïque ayant une structure multicouche se composant d'une couche de semi-conducteur non monocristallin de type conducteur, d'une couche de silicium microcristallin qui est sensiblement intrinsèque et qui sert de couche de conversion photoélectrique contribuant à la génération d'énergie et d'une autre couche de semi-conducteur non monocristallin de type conducteur ;

ledit dispositif photovoltaïque empilé étant **caractérisé en ce que** ladite couche de silicium microcristallin en tant que couche de conversion photoélectrique dans la seconde unité photovoltaïque a un rapport $\alpha_2$ (= I(Si-O)/I(Si-H)) supérieur à un rapport $\alpha_1$ (= I(Si-O)/I(Si-H)) de ladite couche de silicium amorphe en tant que couche de conversion photoélectrique dans la première unité photovoltaïque, où I(Si-O) est une zone de pic pour le mode d'étirement Si-O de chaque couche de silicium et I(Si-H) est une zone de pic pour le mode d'étirement Si-H de chaque couche de silicium, lorsque cela est mesuré par spectroscopie d'absorption infrarouge ; et une intensité de court-circuit Isc$_2$ de la seconde unité photovoltaïque est supérieure à une intensité de court-circuit Isc$_1$ de la première unité photovoltaïque.

**2.** Dispositif photovoltaïque empilé selon la revendication 1, **caractérisé en ce que** chacune desdites couches de semi-conducteur non monocristallin est une couche de silicium non monocristallin ou une couche d'alliage de silicium non monocristallin.

FIG. 1

FIG. 2

FIG. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11243218 A

- US 20020011264 A